# EUROPÄISCHE PATENTSCHRIFT

(11) **EP 2 529 413 B1**
(45) Veröffentlichungstag und Bekanntmachung des Hinweises auf die Patenterteilung: **06.11.2013**
(21) Anmeldenummer: 10790444.3
(22) Anmeldetag: 14.12.2010
(51) Int. Cl.: H01L 31/052, H01L 31/055

(54) **SONNENLICHTKOLLEKTOR UND SONNENLICHTKOLLEKTORENANORDNUNG**
SOLAR COLLECTOR AND SOLAR COLLECTOR SYSTEM
CAPTEUR SOLAIRE ET ENSEMBLE CAPTEUR SOLAIRE

(30) Priorität: 26.01.2010 DE 102010001201
(43) Veröffentlichungstag der Anmeldung: 05.12.2012
(73) Patentinhaber: Robert Bosch GmbH, 70442 Stuttgart (DE)
(72) Erfinder: RAMSTEINER, Ingo, 71229 Leonberg (DE)
(86) Internationale Anmeldenummer: PCT/EP2010/069572
(87) Internationale Veröffentlichungsnummer: WO 2011/091902

(56) Entgegenhaltungen:
- EP-A2- 1 659 347
- WO-A2-2009/002943
- WO-A2-2009/024509
- DE-A1- 2 737 847
- DE-A1- 3 522 602

## Beschreibung

Die Erfindung betrifft einen Sonnenlichtkollektor, insbesondere einen Lumineszenz-Sonnenlichtkollektor, sowie eine Sonnenlichtkollektorenanordnung zur Umwandlung von Sonnenlichtenergie in elektrische Energie.

### Stand der Technik

Höhere Konversionsraten bei reduzierten Kosten sind die Hauptziele der For-schung und Entwicklung im Bereich von Sonnenlichtkollektoren. Der Wirkungsgrad von aktuellen Solarzellen aus kristallinem Silizium ist jedoch bereits sehr nahe am physikalischen Limit angelangt. Andere Solarzellentypen mit höheren Wirkungsgraden sind deutlich teurer. Kostengünstigere Technologien, wie z.B. Dünnschichtsolarzellen oder organische Solarzellen, hingegen verfügen über deutlich kleinere Wirkungsgrade.

Klassische Sonnenlichtkollektoren bündeln Sonnenlicht mit Linsen oder Hohlspiegeln auf kleine aber effiziente Solarzellen, die auf diese Weise einen relativ hohen Wirkungsgrad aufweisen. Nachteilig ist jedoch, dass die Optiken der Sonne mechanisch nachgeführt werden müssen.

Lumineszenz-Sonnenlichtkollektoren benötigen keine Nachführung. Sie bestehen meist aus einer Substratanordnung welche mit einer Solarzelle verbunden ist, wobei die Substratanordnung aus einer transparenten Substratschicht, vorzugsweise hergestellt aus einem Glas oder einem Kunststoff, ausgebildet ist, welche mit einer fluoreszierenden Schicht versehen ist. Die fluoreszierende Schicht kann beispielsweise aus organischen Farbstoffen, Quantenpunkten oder komplexeren Systemen bestehen. Das auf den Sonnenlichtkollektor treffende Sonnenlicht einer bestimmten Wellenlänge wird von der fluoreszierenden Schicht absorbiert und das daraufhin entstehende Fluoreszenzlicht wird in der Substratschicht an die an der Substratanordnung vorgesehene Solarzelle geleitet, wobei die Solarzelle auf die spezielle Wellenlänge des absorbierten Sonnenlichts abgestimmt ist. Mehrere solcher Sonnenlichtkollektoren können zu einer Tandemanordnung verbaut werden, wodurch bei einer entsprechenden Wahl der fluoreszierenden Schichten und auf die entsprechenden Wellenlängen abgestimmten Solarzellen alle Spektralbereiche des Sonnenlichts genutzt werden können. Eine derartiger Lumineszenz-Sonnenlichtkollektor ist beispielsweise aus der US 4,488,047 bekannt.

Nachteilig hierbei ist jedoch, dass es beim Leiten des Fluoreszenzlichts durch die Substratschicht bei einer Reflektion des Fluoreszenzlichts an der auf der Substratschicht vorgesehenen fluoreszierenden Schicht zu einer Reabsorption des Fluoreszenzlichts kommen kann, wodurch hohe Verluste entstehen können und dadurch der Wirkungsgrad des Sonnenlichtkollektors reduziert wird.

### Offenbarung der Erfindung

Es ist daher die Aufgabe der Erfindung, einen Sonnenlichtkollektor, insbesondere einen Lumineszenz-Sonnenlichtkollektor, zur Verfügung zu stellen, welcher sich durch einen verbesserten Wirkungsgrad auszeichnet.

Die Lösung der Aufgabe erfolgt erfindungsgemäß durch die Merkmale des Anspruchs 1. Vorteilhafte Ausgestaltungen der Erfindung sind in den Unteransprüchen angegeben.

Der erfindungsgemäße Sonnenlichtkollektor, insbesondere Lumineszenz-Sonnenlichtkollektor, weist eine mit einer Solarzelle verbundene Substratanordnung auf, wobei die Substratanordnung aus mindestens einer ersten Substratschicht und einer zweiten Substratschicht ausgebildet ist, wobei die erste Substratschicht und die zweite Substratschicht treppenförmig aufeinander angeordnet und als Lichtleiter ausgebildet sind, wobei jede Substratschicht mindestens einen freiliegenden Bereich aufweist, welcher mit einer fluoreszierenden Schicht versehen ist und das der Bereich einer Substratschicht, welcher nicht freiliegend ist keine fluoreszierende Schicht aufweist.

Erfindungsgemäß ist es vorgesehen, dass die Substratoranordnung nun nicht mehr nur aus einer Substratschicht, sondern aus mindestens zwei, vorzugsweise aus mehr als zwei Substratschichten, ausgebildet ist. Die einzelnen Substratschichten sind zueinander treppenförmig ausgebildet, was bedeutet, dass sie Stufen bilden. Jede Substratschicht weist somit eine gegenüber den anderen Substratschichten verschieden große Flächengröße auf, wobei die Substratschichten derart aufeinander angeordnet sind, dass sie nach einer Flächengröße sortiert sind, so das beispielsweise die oberste Substratschicht einer Substratanordnung die kleinste Fläche aufweist. Durch das Aufeinanderanordnen in Abhängigkeit der Flächengröße ist die treppenförmige Ausbildung der Substratschichten zueinander möglich. Jede dieser aufeinanderangeordneten Substratschichten weist einen freiliegenden Bereich auf, d. h. einen Bereich, welcher nicht von einer darüber angeordneten Substratschicht bedeckt ist. Dieser freiliegende Bereich ist mit der fluoreszierenden Schicht versehen. Der Bereich einer Substratschicht, welcher nicht freiliegend ist, sondern von einer anderen Substratschicht abgedeckt ist, weist keine fluoreszierende Schicht auf, so dass dieser Bereich ausschließlich als Lichtleiter des Fluoreszenzlichts fungieren kann. Durch die treppenförmige Ausbildung der Substratschichten zueinander kann gegenüber einer aus nur einer Substratschicht ausgebildeten Substratanordnung die gleiche Fläche der Substratanordnung mit der fluoreszierenden Schicht versehen sein, so dass auch bei der erfindungsgemäßen Ausgestaltung des Sonnenlichtkollektors die gesamte Fläche der Substratanordnung zur Sonnenlichternte genutzt werden kann, wobei jedoch mögliche Reabsorptionsverluste wenn überhaupt nur über kürzere Strecken hinweg auftreten können, wodurch der Wirkungsgrad des gesamten Sonnenlichtkollektors wesentlich erhöht werden kann. In Abhängigkeit davon, wo das Sonnenlicht auf den Sonnenlichtkollektor auftrifft, d. h. auf welcher fluoreszierenden Schicht einer Substratschicht, wird das Fluoreszenzlicht über die erste Substratschicht oder die zweite Substratschicht oder möglicher weiterer Substratschichten zu der Solarzelle geleitet, um dort in elektrische Energie umgewandelt zu werden. Mittels des erfindungsgemäßen Sonnenlichtkollektors ist somit eine Steigerung des Stromertrags bezogen auf die Sonnenlichtkollektorenfläche möglich.

Bevorzugt ist es vorgesehen, dass in einem Überlappungsbereich zwischen der ersten Substratschicht und der zweiten Substratschicht die erste Substratschicht und die zweite Substratschicht beabstandet zueinander angeordnet sind. Die einzelnen Substratschichten der Substratanordnung sind somit nicht unmittelbar aufeinander angeordnet, sondern mit einem bestimmten Abstand zueinander angeordnet. Dadurch kann insbesondere im Überlappungsbereich zweier zueinander benachbarter Substratschichten verhindert werden, dass sich das in eine Substratschicht der Substratanordnung befindliche Fluoreszenzlicht in eine andere, dazu benachbarte Substratschicht übertreten kann. Dadurch wird eine gezielte Führung des Fluoreszenzlichts innerhalb einer Substratschicht hin zu der Solarzelle gewährleistet.

Die zueinander beabstandete Anordnung ist vorzugsweise mittels eines zwischen der ersten Substratschicht und der zweiten Substratschicht vorgesehenen Luftspalts ausgebildet. Durch das Vorsehen eines Luftspalts kann ohne der Zuhilfenahme zusätzlicher Bauteile eine effiziente Trennung zwischen zueinander benachbarter Substratschichten im Überlappungsbereich erfolgen. Um zu verhindern, dass Wasser oder Schmutz in den Luftspalt eindringen kann, ist dieser vorzugsweise an seinen Randbereich verschlossen bzw. verkapselt ausgebildet.

Im Bereich des Luftspaltes ist bevorzugt mindestens ein Abstandshalter vorgesehen. Der bzw. die Abstandshalter verhindern, dass sich die Substratschichten aufgrund ihrer Eigenlast durchbiegen können und es dadurch eventuell zu einem unerwünschten Kontakt zwischen benachbarter Substratschichten kommen könnte. Die Abstandshalter können verschiedenartig ausgebildet sein. Sind die Substratschichten beispielsweise aus einem Kunststoff hergestellt, so können die Abstandshalter je nach Fertigungsverfahren der Substratschichten bereits bei der Formgebung kostengünstig bereits in die Substratschichten integriert werden. Sind die Substratschichten aus Glas hergestellt, können beispielsweise monodisperse Mikrokugeln als Abstandshalter verwendet werden.

Alternativ zu der Ausbildung eines Luftspalts im Überlappungsbereich zweier zueinander benachbarter Substratschichten ist es vorzugsweise vorgesehen, dass die zueinander beabstandete Anordnung mittels einer zwischen der ersten Substratschicht und der zweiten Substratschicht vorgesehenen aus einem spiegelnden Material ausgebildeten Schicht ausgebildet ist.

Weiter ist es bevorzugt vorgesehen, dass die erste Substratschicht und die zweite Substratschicht an einem ersten Endabschnitt bündig miteinander abschließen, wobei an den bündig miteinander abschließenden ersten Endabschnitt die Solarzelle vorgesehen ist. Dadurch ist es möglich, dass eine Kontaktierung aller Substratschichten einer Substratanordnung an einer einzigen Solarzelle erfolgen kann.

Ferner betrifft die Erfindung eine Sonnenlichtkollektorenanordnung, insbesondere eine Lumineszenz-Sonnenlichtkollektorenanordnung, umfassend einen ersten wie vorstehend aus- und weitergebildeten Sonnenlichtkollektor zur Absorption von Sonnenlicht einer ersten Wellenlänge und einen zweiten wie vorstehend ausund weitergebildeten Sonnenlichtkollektor zur Absorption von Sonnenlicht einer zweiten Wellenlänge.

Mehrere Sonnenlichtkollektoren, insbesondere mehrere Lumineszenz-Sonnenlichtkollektoren, können damit in Form einer Tandemanordnung zu einer Sonnenlichtkollektorenanordnung zusammengefügt werden. Dadurch, dass jeder Sonnenlichtkollektor dieser Anordnung Sonnenlicht einer bestimmten Wellenlänge absorbieren kann, kann mit dieser erfindungsgemäßen Anordnung ein großer Spektralbereich des Sonnenlichts abgedeckt werden, wobei gleichzeitig die Vorteile eines zuvor beschriebenen erfindungsgemäßen Sonnenlichtkollektors genutzt werden können. Die Anordnung der einzelnen Sonnlichtkollektoren zueinander erfolgt dabei vorzugsweise derart, dass sie entsprechend einer spektralen Optimierung zueinander angeordnet sind, wobei der Sonnenlichtkollektor, welcher Sonnenlicht mit der höchsten Energie und damit mit der kürzesten Wellenlänge absorbieren kann, dem einfallenden Sonnenlicht am nächsten innerhalb der erfindungsgemäßen Anordnung vorgesehen ist.

Bevorzugt ist es hierbei vorgesehen, dass die freiliegenden Bereiche der Substratschichten des ersten Sonnenlichtkollektors auf den freiliegenden Bereichen der Substratschichten des zweiten Sonnenlichtkollektors angeordnet sind. Dadurch ist es möglich, trotz der treppenförmigen Ausgestaltung der Substratschichten zueinander einer Substratanordnung mehrere baugleiche Substratanordnungen Platz sparend übereinander stapeln zu können. Durch diese Anordnung zueinander können die fluoreszierenden Schichten auf den freiliegenden Bereichen ohne eine zusätzlich vorzusehende Verkapselung vor Umwelteinflüssen geschützt werden.

### Kurze Beschreibung der Zeichnungen

Nachfolgend wird die Erfindung unter Bezugnahme auf die anliegenden Zeichnungen anhand bevorzugter Ausführungsbeispiele näher erläutert.

Es zeigen:
- Fig. 1: eine schematische Darstellung einer Sonnenlichtkollektorenanordnung gemäß dem Stand der Technik;
- Fig. 2: eine schematische Darstellung eines Sonnenlichtkollektors gemäß der Erfindung; und
- Fig. 3: eine schematische Darstellung einer Sonnenlichtkollektorenanordnung gemäß der Erfindung.

### Beschreibung der Abbildung

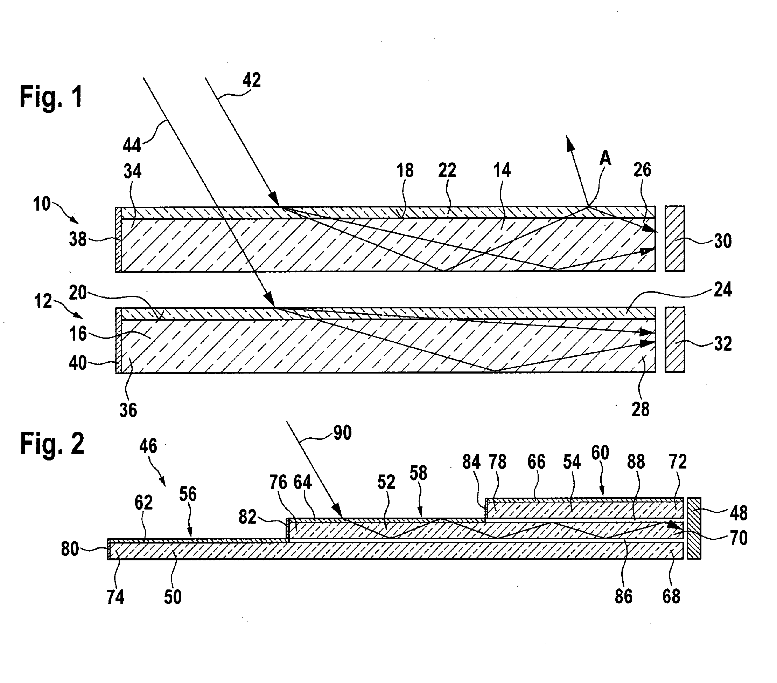

Fig. 1 zeigt schematisch eine aus dem Stand der Technik bekannte Sonnenlichtkollektorenanordnung in Form einer Tandemanordnung, welche aus einem ersten Sonnenlichtkollektor 10 zur Absorption von Sonnenlicht einer ersten Wellenlänge und einem zweiten Sonnenlichtkollektors 12 zur Absorption von Sonnenlicht einer zweiten Wellenlänge aufgebaut ist. Die Sonnenlichtkollektoren 10, 12 weisen jeweils eine Substratanaordnung mit einer transparenten Substratschicht 14, 16 auf, welche auf einer Oberfläche 18, 20 der Substratschichten 14, 16 über ihre ganze Länge mit einer fluoreszierenden Schicht 22, 24 versehen sind. An einem ersten Endabschnitt 26, 28 der Substratschichten 14, 16 sind die Sonnenlichtkollektoren 10, 12 jeweils mit einer Solarzelle 30, 32 verbunden und an einem dem ersten Endabschnitt 26, 28 gegenüberliegenden zweiten Endabschnitt 34, 36 der Substratschichten 14, 16 ist jeweils ein Spiegel 38, 40 vorgesehen.

Die erste Substratanordnung bzw. die erste Substratschicht 14 kann kurzwelliges Sonnenlicht, mit dem Pfeil 42 gekennzeichnet, absorbieren und emittiert dabei entstehendes Fluoreszenzlicht größerer Wellenlänge, das teilweise in die Substratschicht 14 eingekoppelt wird und wie in einem Lichtleiter auf die Solarzelle 30 am ersten Endabschnitt 26 gelenkt wird. Bei Reflektion an der fluoreszierenden Schicht 22, wie in Punkt A gezeigt, kann es zu Verlusten des in der Substratschicht geführten Fluoreszenzlichts durch Reabsorption kommen. Der zweite Sonnenlichtkollektor 12 kann durch den ersten Sonnenlichtkollektor 10 transmittiertes Sonnenlicht 44 durch einen anderen in der fluoreszierenden Schicht 24 enthaltenden Farbstoff in Fluoreszenz größerer Wellenlänge gewandelt werden, als dies bei dem ersten Sonnenlichtkollektor 10 der Fall ist, und diese ebenfalls in Richtung einer Solarzelle 32 des zweiten Sonnenlichtkollektors 12 leiten. Die Substratanordnungen weisen hier jeweils nur eine Substratschicht 14, 16 auf, welche auf einer Oberfläche 18, 20 vollständig mit einer fluoreszierenden Schicht 22, 24 versehen ist, wobei die Substratschichten 14, 16 vorzugsweise die gleiche Fläche aufweisen.

Fig. 2 zeigt schematisch einen Sonnenlichtkollektor 46 für Sonnenlicht einer bestimmten Wellenlänge gemäß der Erfindung, welcher eine mit einer Solarzelle 48 verbundene Substratanordnung aufweist, wobei die Substratanordnung aus drei treppenförmig zueinander angeordneten Substratschichten 50, 52, 54 ausgebildet ist, wobei jede Substratschicht 50, 52, 54 einen freiliegenden Bereich 56, 58, 60, welcher nicht von einer benachbarten Substratschicht 50, 52, 54 bedeckt ist, aufweist, wobei die freiliegenden Bereiche 56, 58, 60 mit einer fluoreszierenden Schicht 62, 64, 66 versehen sind. Die Substratschichten 50, 52, 54 sind vorzugsweise eben ausgebildet und parallel zueinander angeordnet, wobei die Substratschichten 50, 52, 54 beispielsweise aus Kunststoff oder Glas hergestellt sein können. Die Substratschichten 50, 52, 54 weisen einen ersten Endabschnitt 68, 70, 72 auf, wobei die Substratschichten 50, 52, 54 an diesem Endabschnitt 68, 70, 72 bündig zueinander abschließen und mit der Solarzelle 48 verbunden sind. An einem zweitem, dem ersten Endabschnitt 68, 70, 72 gegenüberliegenden Endabschnitt 74, 76, 78, weisen die Substratschichten 50, 52, 54 jeweils einen Spiegel 80, 82, 84 auf. In dem Bereich 86, 88, wo sich zwei übereinander bzw. benachbart angeordnete Substratschichten 50, 52, 54 überlappen, weisen die Substratschichten 50, 52, 54 keine fluoreszierende Schicht auf, sondern sind mit einem bestimmten Abstand zueinander angeordnet, wobei der Abstand beispielsweise in Form eines Luftspalts oder einer aus einem spiegelnden Material ausgebildeten Schicht ausgebildet sein kann.

Die erfindungsgemäße Substratanordnung weist somit mehr als eine Substratschicht 50, 52, 54 mit unterschiedlich großen Flächen auf, welche treppenförmig aufeinander angeordnet sind und nur bereichsweise mit einer fluoreszierenden Schicht 62, 64, 66 versehen sind, wobei die Substratanordnung jedoch, genauso wie im Stand der Technik, über seine gesamte freiliegende Fläche mit der fluoreszierenden Schicht 62, 64, 66 versehen ist. Beim Herstellen des Sonnenlichtkollektors 46 kann die fluoreszierende Schicht 62, 64, 66 in einem Arbeitsgang auf den zusammengefügten Stapel von mehreren Substratschichten 62, 64, 66 aufgebracht werden.

Trifft beispielsweise, wie in Fig. 2 gezeigt, Sonnenlicht 90 einer bestimmten Wellenlänge auf die fluoreszierende Schicht 64 im Bereich der mittleren Substratschicht 52 wird das Sonnenlicht 90 in der fluoreszierenden Schicht 64 absorbiert und das dadurch entstehende Fluoreszenzlicht wird entlang der mittleren Substratschicht 64 zu der Solarzelle 48 geleitet, wobei im Überlappungsbereich 86, 88 keine Reabsorptionsverluste des Fluoreszenzlichts entstehen können.

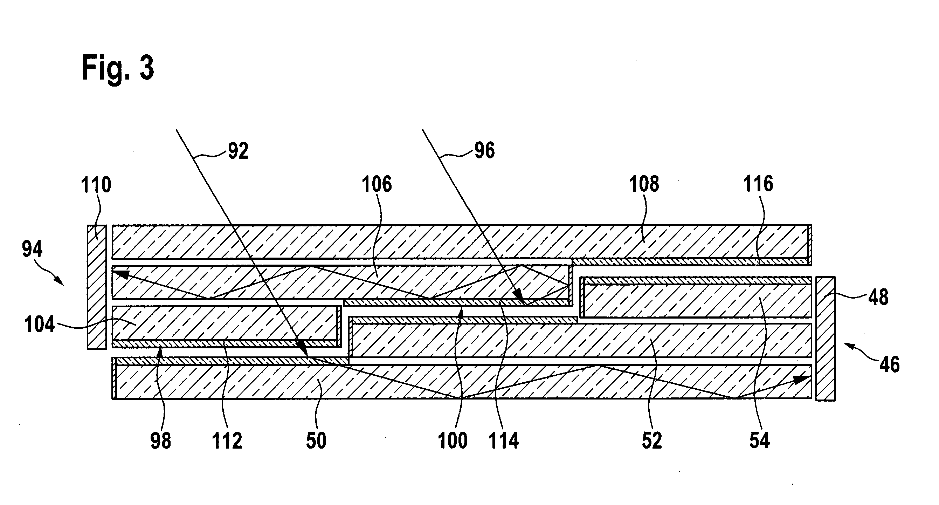

Fig. 3 zeigt eine Sonnenlichtkollektorenanordnung in Form einer Tandemanordnung mit einem ersten, wie in Fig. 2 gezeigten, Sonnlichtkollektor 46 zur Absorption von Sonnenlicht 92 einer ersten Wellenlänge und einem zweiten, zu dem ersten Sonnenlichtkollektor 46 baugleichen Sonnenlichtkollektor 94 zur Absorption von Sonnenlicht 96 einer zweiten Wellenlänge, wobei der Sonnenlichtkollektor 94, welcher dem einfallenden Sonnenlicht 92, 96 am nächsten angeordnet ist, dafür ausgelegt ist, das Sonnenlicht 96 mit der kürzeren Wellenlänge zu absorbieren. Sonnenlicht 92 mit einer längeren Wellenlänge durchdringt den zweiten Sonnenlichtkollektor 94 und wird von einer fluoreszierenden Schicht 62 des ersten Sonnenlichtkollektors 46 absorbiert. Das dabei entstehende Fluoreszenzlicht wird in die Substratschicht 50 eingekoppelt und zu der Solarzelle 48 geleitet. Die Sonnenlichtkollektoren 46, 94 sind dabei derart zueinander angeordnet, dass die freiliegenden Bereiche 56, 58, 60 der Substratschichten 50, 52, 54 des ersten Sonnenlichtkollektors 46 auf den freiliegenden Bereichen 98, 100, 102 der Substratschichten 104, 106, 108 des zweiten Sonnenlichtkollektors 94 angeordnet sind.

## Patentansprüche

1. Sonnenlichtkollektor, insbesondere Lumineszenz-Sonnenlichtkollektor,
umfassend
eine mit einer Solarzelle (48) verbundene Substratanordnung,
wobei die Substratanordnung aus mindestens einer ersten Substratschicht (50, 52, 54) und einer zweiten Substratschicht (50, 52, 54) ausgebildet ist, wobei die erste Substratschicht (50, 52, 54) und die zweite Substratschicht (50, 52, 54) treppenförmig aufeinander angeordnet und als Lichtleiter ausgebildet sind, **dadurch gekennzeichnet, dass**
jede Substratschicht (50, 52, 54) mindestens einen freiliegenden Bereich (56, 58, 60) aufweist,
welcher mit einer fluoreszierenden Schicht (62, 64, 66) versehen ist und dass der Bereich einer Substratschicht welcher nicht freiliegend ist keine fluoreszierende Schicht aufweist.

2. Sonnenlichtkollektor nach Anspruch 1, **dadurch gekennzeichnet, dass** in einem Überlappungsbereich (86, 88) zwischen der ersten Substratschicht (50, 52, 54) und der zweiten Substratschicht (50, 52, 54) die erste Substratschicht (50, 52, 54) und die zweite Substratschicht (50, 52, 54) beabstandet zueinander angeordnet sind.

3. Sonnenlichtkollektor nach Anspruch 2, **dadurch gekennzeichnet, dass** die zueinander beabstandete Anordnung mittels eines zwischen der ersten Substratschicht (50, 52, 54) und der zweiten Substratschicht (50, 52, 54) vorgesehenen Luftspalts ausgebildet ist.

4. Sonnenlichtkollektor nach Anspruch 3, **dadurch gekennzeichnet, dass** im Bereich des Luftspalts mindestens ein Abstandshalter vorgesehen ist.

5. Sonnenlichtkollektor nach Anspruch 2, **dadurch gekennzeichnet, dass** die zueinander beabstandete Anordnung mittels einer zwischen der ersten Substratschicht (50, 52, 54) und der zweiten Substratschicht (50, 52, 54) vorgesehenen aus einem spiegelnden Material ausgebildeten Schicht (80, 82, 84) ausgebildet ist.

6. Sonnenlichtkollektor nach einem der Ansprüche 1 bis 5, **dadurch gekennzeichnet, dass** die erste Substratschicht (50, 52, 54) und die zweite Substratschicht (50, 52, 54) an einem ersten Endabschnitt (68, 70, 72) bündig miteinander abschließen, wobei an den bündig miteinander abschließenden ersten Endabschnitten (68, 70, 72) die Solarzelle (48) vorgesehen ist.

7. Sonnenlichtkollektorenanordnung, umfassend einen ersten Sonnenlichtkollektor (46) nach einem der Ansprüche 1 bis 6 zur Absorption von Sonnenlicht einer ersten Wellenlänge (92) und einen zweiten Sonnenlichtkollektor (94) nach einem der Ansprüche 1 bis 6 zur Absorption von Sonnenlicht (96) einer zweiten Wellenlänge.

8. Sonnenlichtkollektorenanordnung nach Anspruch 7, **dadurch gekennzeichnet, dass** die freiliegenden Bereich (56, 58, 60) der Substratschichten (50, 52, 54) des ersten Sonnenlichtkollektors (46) auf den freiliegenden Bereichen (98, 100, 102) der Substratschichten (104, 106, 108) des zweiten Sonnenlichtkollektors (94) angeordnet sind.

## Claims

1. Solar collector, especially a luminescent solar collector, comprising a substrate system connected to a solar cell (48), the substrate system being formed by at least a first substrate layer (50, 52, 54) and a second substrate layer (50, 52, 54), the first substrate layer (50, 52, 54) and the second substrate layer (50, 52, 54) being arranged one on top of the other in a step-like manner and being formed as light guides, **characterized in that** each substrate layer (50, 52, 54) has at least one exposed region (56, 58, 60), which is provided with a fluorescent layer (62, 64, 66), and **in that** the region of a substrate layer that is not exposed does not have a fluorescent layer.

2. Solar collector according to Claim 1, **characterized in that**, in an overlapping region (86, 88) between the first substrate layer (50, 52, 54) and the second substrate layer (50, 52, 54), the first substrate layer (50, 52, 54) and the second substrate layer (50, 52, 54) are arranged at a distance from one another.

3. Solar collector according to Claim 2, **characterized in that** the arrangement at a distance from one another is formed by means of an air gap provided between the first substrate layer (50, 52, 54) and the second substrate layer (50, 52, 54).

4. Solar collector according to Claim 3, **characterized in that** at least one spacer is provided in the region of the air gap.

5. Solar collector according to Claim 2, **characterized in that** the arrangement at a distance from one another is formed by means of a layer (80, 82, 84) formed from a reflective material that is provided between the first substrate layer (50, 52, 54) and the second substrate layer (50, 52, 54).

6. Solar collector according to one of Claims 1 to 5, **characterized in that** the first substrate layer (50, 52, 54) and the second substrate layer (50, 52, 54) finish flush with one another at a first end portion (68, 70, 62), the solar cell (48) being provided at the first end portions (68, 70, 72) that finish flush with one another.

7. Solar collector system, comprising a first solar collector (46) according to one of Claims 1 to 6 for the absorption of sunlight (92) of a first wavelength and a second solar collector (94) according to one of Claims 1 to 6 for the absorption of sunlight (96) of a second wavelength.

8. Solar collector system according to Claim 7, **characterized in that** the exposed regions (56, 58, 60) of the substrate layers (50, 52, 54) of the first solar collector (46) are arranged on the exposed regions (98, 100, 102) of the substrate layers (104, 106, 108) of the second solar collector (94).

## Revendications

1. Collecteur de lumière solaire, en particulier collecteur de lumière solaire à luminescence, comprenant
un ensemble de substrat relié à une cellule solaire (48),
l'ensemble de substrat étant formé d'au moins une première couche de substrat (50, 52, 54) et d'une deuxième couche de substrat (50, 52, 54),
la première couche de substrat (50, 52, 54) et la deuxième couche de substrat (50, 52, 54) étant disposées l'une au-dessus de l'autre en escalier et étant configurées comme conducteurs de lumière, **caractérisé en ce que**
chaque couche de substrat (50, 52, 54) présente au moins une partie libre (56, 58, 60) dotée d'une couche fluorescente (62, 64, 66) et
**en ce que** la partie de couche de substrat qui n'est pas libre ne présente pas de couche fluorescente.

2. Collecteur de lumière solaire selon la revendication 1, **caractérisé en ce que** dans une zone de superposition (86, 88) entre la première couche de substrat (50, 52, 54) et la deuxième couche de substrat (50, 52, 54), la première couche de substrat (50, 52, 54) et la deuxième couche de substrat (50, 52, 54) sont disposées à distance l'une de l'autre.

3. Collecteur de lumière solaire selon la revendication 2, **caractérisé en ce que** l'ensemble de couches situées à distance l'une de l'autre est formé au moyen d'un interstice d'air prévu entre la première couche de substrat (50, 52, 54) et la deuxième couche de substrat (50, 52, 54).

4. Collecteur de lumière solaire selon la revendication 3, **caractérisé en ce qu'**au moins un écarteur est prévu au niveau de l'interstice d'air.

5. Collecteur de lumière solaire selon la revendication 2, **caractérisé en ce que** l'ensemble de couches maintenues à distance l'une de l'autre est formé au moyen d'une couche (80, 82, 84) formée d'un matériau réfléchissant et prévue entre la première couche de substrat (50, 52, 54) et la deuxième couche de substrat (50, 52, 54).

6. Collecteur de lumière solaire selon l'une des revendications 1 à 5, **caractérisé en ce que** la première couche de substrat (50, 52, 54) et la deuxième couche de substrat (50, 52, 54) se raccordent l'une à l'autre à chant dans une première partie d'extrémité (68, 70, 72), la cellule solaire (48) étant prévue sur les premières parties d'extrémité (68, 70, 72) qui se raccordent l'une à l'autre à chant.

7. Ensemble de collecteur de lumière solaire comprenant un premier collecteur (46) de lumière solaire selon l'une des revendications 1 à 6, pour l'absorption de lumière solaire (92) d'une première longueur d'onde et un deuxième collecteur (94) de lumière solaire selon l'une des revendications 1 à 6 pour l'absorption de lumière solaire (96) d'une deuxième longueur d'onde.

8. Ensemble de collecteur de lumière solaire selon la revendication 7, **caractérisé en ce que** les parties libres (56, 58, 60) des couches de substrat (50, 52, 54) du premier collecteur (46) de lumière solaire sont disposées sur les parties libres (98, 100, 102) des couches de substrat (104, 106, 108) du deuxième collecteur (94) de lumière solaire.
